# EUROPEAN PATENT SPECIFICATION

(11) **EP 0 596 533 B1**
(45) Date of publication and mention of the grant of the patent: **29.04.1998**
(21) Application number: 93118009.5
(22) Date of filing: 05.11.1993
(51) Int. Cl.: H05K 13/04, H05K 13/08

(54) **Method for mounting components on a substrate and component mounting machine therefor**
Verfahren zur Befestigung von Bauelementen auf einem Substrat und Bestückungsmaschine hierfür
Procédé pour fixer des composants sur un substrat et machine de montage de composants pour ce faire

(30) Priority: 05.11.1992 JP 296124/92
(43) Date of publication of application: 11.05.1994
(60) Divisional application: 96106676.8
(73) Proprietor: YAMAHA HATSUDOKI KABUSHIKI KAISHA, Iwata-shi Shizuoka-ken, 438 (JP)
(72) Inventor: Onodera, Hitoshi, Iwata-shi, Sizuoka-ken (JP)
(74) Representative: Grünecker, Kinkeldey, Stockmair & Schwanhäusser Anwaltssozietät

(56) References cited:
- EP-A- 0 416 878
- EP-A- 0 471 272
- WO-A-92/14988

## Description

The present invention relates to a method for mounting a minute component onto a substrate, said component being attracted by means of an attracting nozzle disposed on a head unit and is investigated as to its attracted state through a component attracted state detecting system. Moreover, the present invention relates to a component mounting machine for mounting such components, for performing the afore-indicated method.

For mounting minute component such as I.C's, resistors, transisters, condensers, etc., exactly on their specified positions on the substrate, such as a printed circuit board, mounting apparatuses were already suggested which attract a component through an attracting nozzle by vacuum and detecting the attracting position of the component in view of irregularities which can prevent the component from being precisely positioned on the desired spot onto the substrate. Such component mounting apparatuses are, for example, disclosed in the applicant's previous European patent applications No. 93111932.5, 93110535.7, 93110547.2 and 93110537.3 which all belong to the prior art under Article 54(3) EPC.

Therefore, so far a chip component mounting machine as already been suggested on which a chip component, such as a electronic component like I.C., etc., is attracted from a component feeding section by a mounting head unit of the machine, transferred to a prepositioned substrate such as a printed circuit board and is mounted at a predetermined position thereon. Such a mounting machine usually has a head unit adapted for moving in the X-axis and Y-axis directions and at least one attracting nozzle adapted for moving in a Z-axis vertical direction. Moreover, the attracting nozzle is rotatable about its vertical R-axis and the head unit is provided with a driving means for movement in various directions and for rotating the attracting nozzle. By controlling these driving means and supply means for applying a negative pressure to the attracting nozzle, the chip component is automatically attracted and mounted.

As the attracting position of the component as attracted to the attracting nozzle tends to imply some undesirable deviations, it is required to correct the mounting position according to the position of deviations of the component and, therefore, it has already been suggested to equip the mounting machine with an optical detecting means composed of a parallel light beam emitting section and a light receiving section for emitting parallel light beams toward the component and detecting the attracted state of the component on the basis of the projection of the component (see WO-A-9 214 988 or EP93110547.2).

In some cases difficulties have arisen with said system as the components to be attracted and mounted have many lead pins projected therefrom which render sometimes a clear detection by the article detecting means difficult.

Moreover, further problems may arise from the fact that it is desirable to provide the head unit with a plurality of attracting nozzles for improving the efficiency of the production. Depending on the size of the components which require recognition it is either desirable to attract and mount components by all of a plurality of attracting nozzles or by using only one or as selected number thereof. Moreover, attention is to be paid to avoid any interference between the components and the attracted state detecting means.

Therefore, it is an objective of the present invention to provide a method for mounting minute components onto a substrate as indicated above which allows a more appropriate approach and adaption of the attracted state detecting system to the type of component to be investigated and instantaneously to be mounted. In other words it is desired to consider to a greater extend the nature and size of the component to be mounted when detecting and evaluating the attracted state of the component.

Moreover, it is a further objective of the present invention to provide an improved component mounting machine as indicated above, particularly adapted for performing said method, having an improved detecting system for evaluating the attracted state of the component, said detecting system enabling to meet a different detecting requirements in response to a different type and nature or size of the component the attracted state of which is to be investigated.

In order to perform the afore-indicated objective in terms of the method, the present invention improves the method for mounting a minute component onto a substrate as defined in claim 1, in that the component is subject to an attracted state detecting investigation either through an optical detecting means or through a photographing means on the basis of a photograph according to a selection of said detecting means in response to the type of component to be mounted.

According to a preferred embodiment of said method, a main processor of a main controller selects one of a laser unit (as the optical detecting means) and a component recognising camera (as the photographing means) to be used for detecting the component attracted state according to the type of the components while controlling the operations of several drive motors through an axis driver unit to automatically attract and mount said components according to the selection of the means for investigating the attracted state of the component.

Further preferred developments of the method according to the present invention are laid down in the further subclaims.

In order to perform the afore-indicated objective in terms of the component mounting machine as defined in the preamble of claim 8, the present invention improves said machine in that at least one photographing means is provided which is selected for detecting the attracted state of a component having many lead pins on the basis of a photograph.

Preferably, said photographing means is a component recognising camera disposed on a base of the machine.

Moreover, according to yet another preferred embodiment of the present invention, said photographing means comprising a photographing assisting member which at least partially constitutes a background for photographing, said photographing assisting member having a through hole for accommodating an attracting nozzle therethrough when photographing same.

According to yet another preferred embodiment of said machine according to the present invention the head unit thereof is provided with a substrate photographing means for detecting the substrate on which the components are to be mounted and that the photographing assisting member is provided with light emitting members and that driving means for driving the photographing assisting member is provided for moving the photographing assisting member from a component photographing position to an operating position of the optical detecting means and to a substrate photographing position corresponding to the substrate photographing means.

The component mounting machine according to this invention, thus, in addition to an optical detecting means for detecting the attracted state of a component on the basis of its projection, is equipped with a photographing means for detecting the attracted state of the component having many lead pins on the basis of a photograph image so that the photographing means and the optical detecting means may be used selectively for detecting the attracted state of the component.

Accordingly, the detecting means can be selected in response to the properties such as size and design of the component to be detected so that correction amounts for the positioning of the component onto the substrate can be more precisely obtained while a smooth interference-free cooperation of all components of the attracted state detecting system as well as of a preferably added substrate recognition system can be assured.

Further preferred embodiments of the component mounting machine according to this invention are laid down in the other subclaims.

With the afore-indicated method and components mounting machine, in its most developed state including all preferred embodiments thereof, when a series of operations of component attraction, attracted state detection, component mounting, etc., are carried out, it is decided which of the photographing means and the optical detecting means is to be used for detecting the component attracted state according to the kind of the component. When the photographing means is used, a preferably provided photographing assisting member constitutes a background for photographing by being brought to the position for component photographing, and, in this state, a through hole of the photographing assisting member allows the first attracting nozzle to move up and down, and a chip component is attracted and mounted by the first attracting nozzle. On the other hand, when the optical detecting means is used, a chip component is attracted and mounted preferably also by the second attracting nozzle with the photographing means kept away from the nozzle installing portion.

Further, if the preferably provided photographing assisting member is provided with a light emitter and is adapted for being moved to the position for photographing the substrate when photographing the substrate by the substrate photographing means installed on the head unit, a light emitter preferably installed on the photographing assisting means is used for lighting both when photographing the component and for photographing the substrate.

In the following the present invention is explained in greater detail through an embodiment thereof in conjunction with the accompanying drawings, wherein:
Figure 1 is an overall plan view of a component mounting machine according a preferred embodiment of this invention, having detecting means for investigating a component attracted state,
Figure 2 is a front view of the component mounting machine of Figure 1,

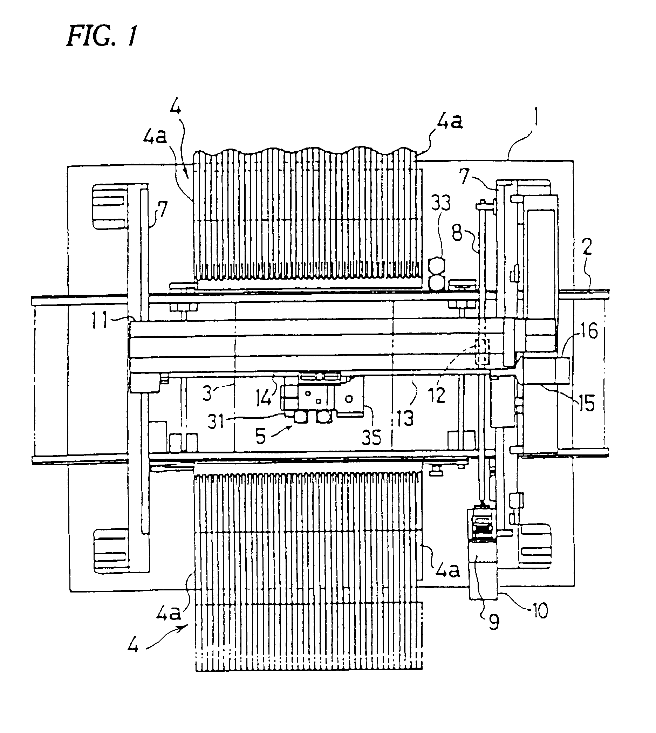

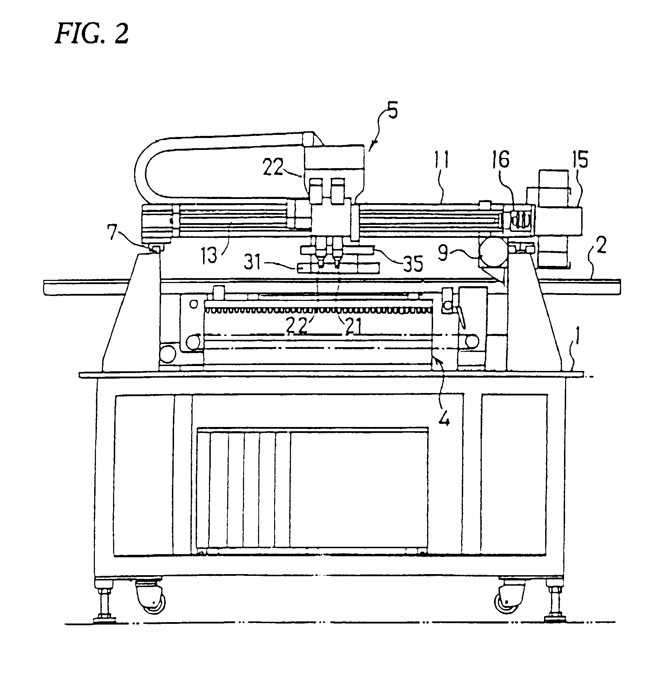

Figure 2 is a front view of the component mounting machine of Figure 1,

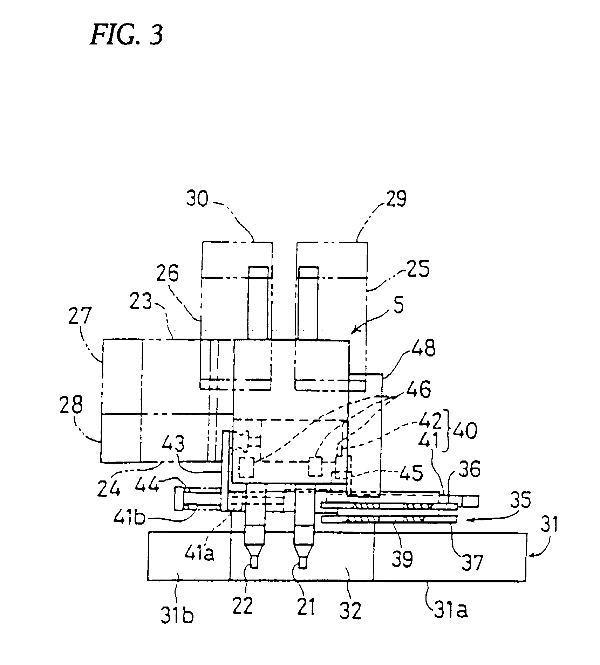

Figure 3 is an enlarged front view of a head unit of the component mounting machine of Figures 1 and 2,

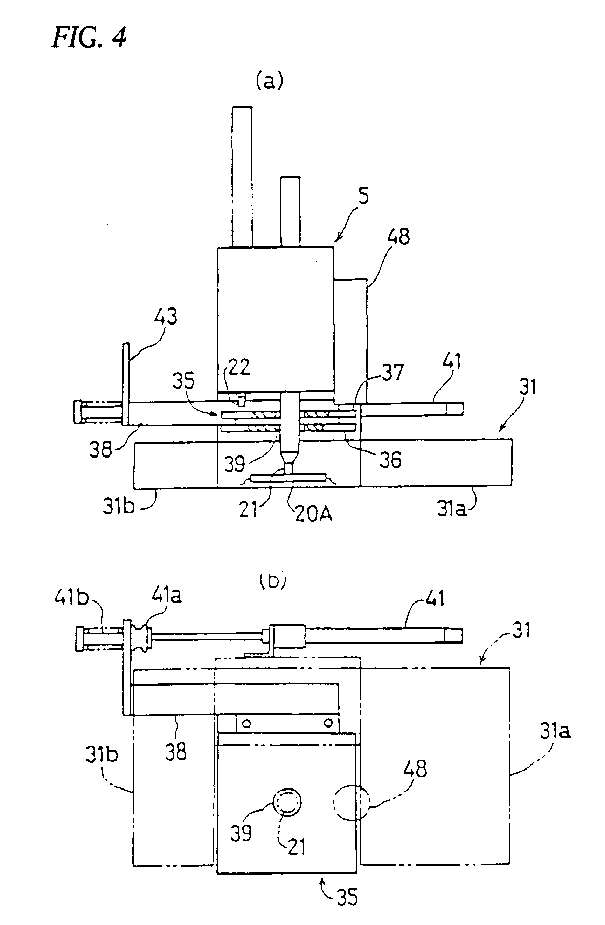

Figure 4a and 4b show the state of the head unit in the case where a component recognising camera is used for detecting the component attracted state with Figure 4a being a schematic front view and Figure 4b being a schematic plan view,

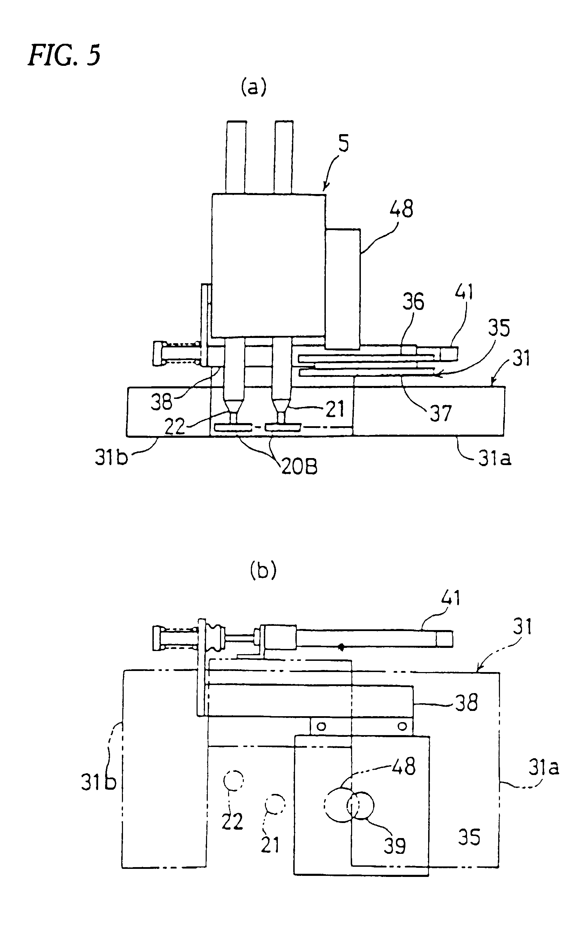

Figures 5a and 5b show the state of a head unit in the case where a laser unit is used for detecting the component attracted state with Figure 5a being a schematic front view and Figure 5b being a schematic plan view,

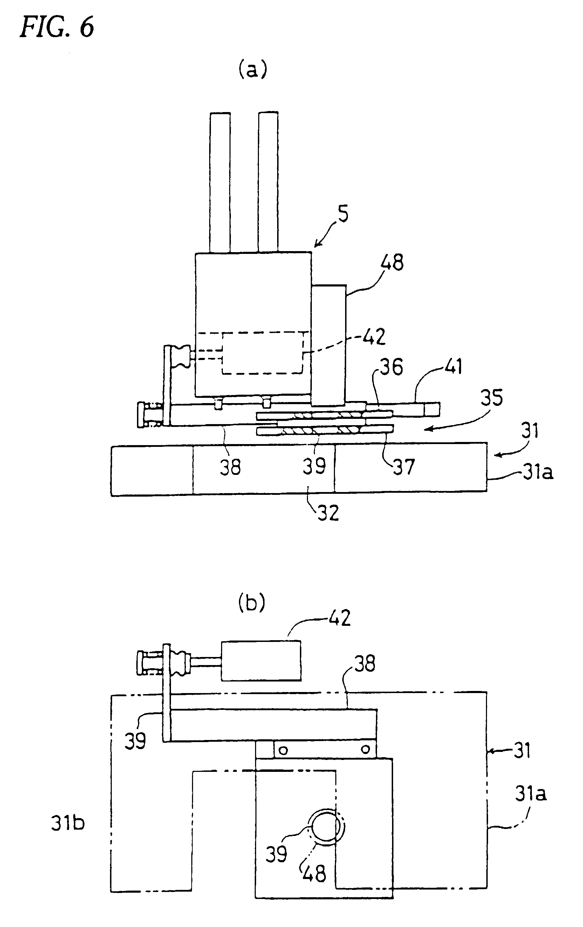

Figure 6a and 6b show the state of a head unit while recognising a substate with Figure 6a being a schematic front view and Figure 6b being a schematic plan view,

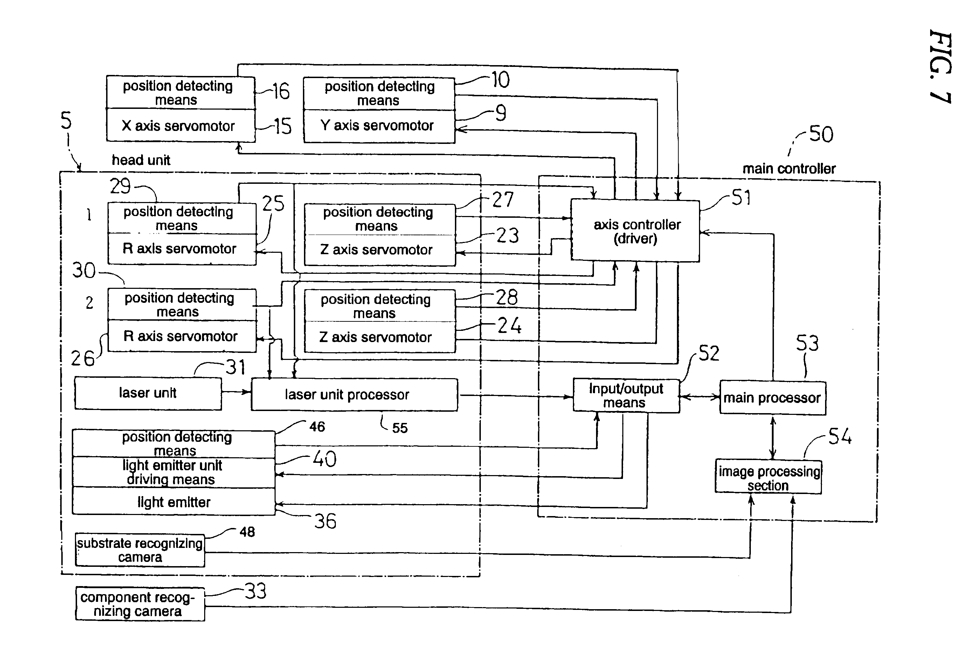

Figure 7 is a block diagram of a control system of the component mounting machine of Figure 1,

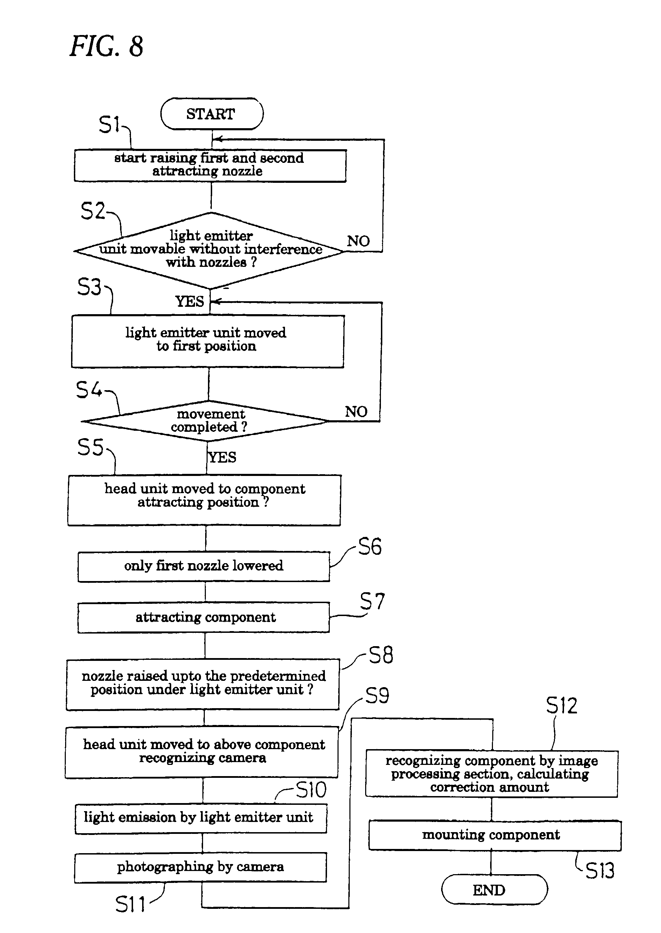

Figure 8 is a flow chart showing the control in the case where a component recognising camera is used for detecting the attracted state of the component,

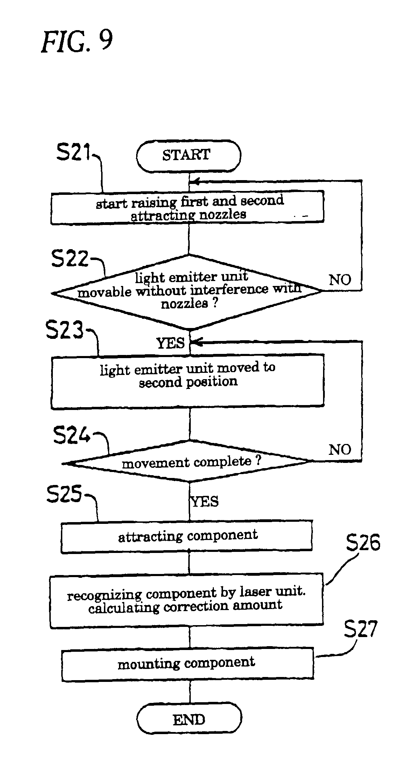

Figure 9 is a flow chart showing the control in the case where a laser unit is used for detecting the attracted state of the component,

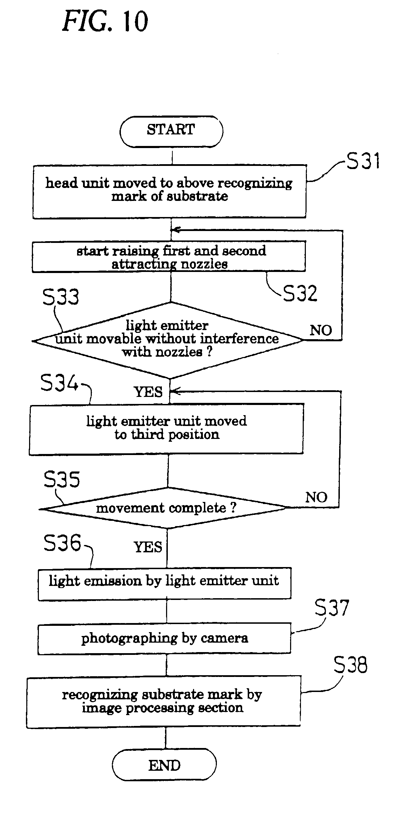

Figure 10 is a flow chart showing the control for recognising a substrate.

An embodiment of this invention is described referring to appended drawings. Fig.1 and Fig.2 show the overall structure of a component mounting machine, an embodiment of this invention. As shown, a conveyer 2 for conveying printed substrates is installed on the base 1, the printed substrate is conveyed on the conveyer 2, and is brought to a stop at a predetermined component mounting position.

On the sides of the conveyer 2 are disposed component feeding sections 4 each provided with many rows of tape feeders 4a. Each tape feeder 4a is adapted for sending out a tape holding and containing chip components 20 such as I.C's, transisters, condensers, etc., at regular intervals from a reel, and is provided with a ratchet type feeder mechanism incorporated at the tape send-out end so that the feeder tape 4a may be intermittently sent out as chip components are picked up by a head unit 5 to be described later.

The head unit 5 adapted for moving both in the X axis direction (direction of the conveyer 2) and in the Y axis direction (direction perpendicular to the X axis direction on a horizontal plane) is installed above the base 1.

That is, while a pair of fixed rails 7 extended in the Y axis direction and a ball screw 8 to be rotated by a Y axis servomotor 9 are disposed on the base 1, a head unit support member 11 is supported on the fixed rails 7, and a nut portion 12 provided on the support member 11 is in screw-engagement with the ball screw 8. The supporting member 11 is provided with a guide member 13 extended in the X-axis direction and a ball screw 14 to be rotated by an X axis servomotor 15, a head unit 5 is movably supported by said guide member 13, and a nut portion (not shown) provided in this head unit 5 is in screw-engagement with the ball screw 14. While the ball screw 8 is rotated by the operation of the Y axis servomotor 9 and the support member 11 is moved in the Y axis direction, the ball screw 14 is rotated by the operation of the X axis servomotor 15 and the head unit 5 is moved in the X axis direction relative to the support member 11.

The Y axis servomotor 9 and X axis servomotor 15 are respectively provided with position detecting means 10 and 16 each constituted of an encoder.

The head unit 5 is provided with first and second attracting nozzles 21, 22. While this head unit is provided with a laser unit 31 as optical detecting means for detecting the attracted state of the chip components on the basis of the projection, a component recognizing camera 33 as photographing means is installed at a suitable position within the head unit moving range on the base 1. Further, the head unit 5 is equipped with a light emitter unit 35 as a photographing assisting member and a substrate recognizing camera 48 as substrate photographing means.

Concretely describing members equipped on the head unit 5 referring to Fig.3, both attracting nozzles 21,22 are made capable of moving in the Z axis direction (up-down direction) and rotating about the R axis (nozzle center axis), and are operated by the Z axis servomotors 23,24 and R axis servomotors 25,26. Each servomotor 23 through 26 is provided with a position detecting means 27 through 30, respectively. Each attracting nozzle 21,22 is connected with a negative pressure supplying means (not shown) through valves, etc., so that component attracting negative pressure may be supplied to the attracting nozzles when required.

The first attracting nozzle 21 is used for component attraction in both cases where the component attracted state is detected by the laser unit 31 and where the component attracted state is detected by the component recognizing camera 33, and is disposed generally at the center of the space corresponding to the space 32 in the laser unit 31. The second attracting nozzle 22 is used for component attraction only in the case where the component attracted state is detected by the laser unit 31, and is disposed slantly on one side of the first nozzle 21.

On the lower end portion of the head unit 5 is installed the laser unit 31. This laser unit 31 has a laser beam generating section (parallel beam emitting section) 31a and a detector (light receiving section) 31b disposed opposite to each other on both sides of a space 32 through which the attracting nozzles 21,22 passes when raised and lowered, and the detector 31b is constituted of a CCD.

The light emitter unit 35 is disposed on the lower portion of the head unit 5 above the laser unit 31. This light emitter unit 35 has a plate-like light emitter 36 composed of a number of LEDs, a diffusing plate 37 positioned under the light emitter 36 and a mounting member 38 for combining these (36 and 37). The diffusing plate constitutes a background for photographing the chip component attracted to the attracting nozzle 21, and is constructed with milk white acril plates, so that the light from the light emitter 36 may be diffused.

This light emitter unit 35 is mounted so as to be movable in the lateral direction relative to the head unit 5 (left-right direction in Fig.3). The light emitter unit 35 has a through hole 39 bored through both light emitter 36 and diffusing plate 37 at the position corresponding to the first attracting nozzle 21 while the light emitter unit is at the first position (See Fig.4) so that the first attracting nozzle 21 may be inserted therein.

Light emitter unit driving means 40 is provided to move the light emitter unit 35, and is constructed with a first cylinder 41 and a second cylinder 42. To the tip end portion of the rod of the first cylinder 41 are connected an expanded portion 41a and a shaft portion 41b. A bracket 43 is connected to the mounting member 38 of the light emitter unit 35 and is movably coupled with the shaft portion 41b, and is pushed against the expanded portion 41a by the urging force of a spring 44. Further, the extended portion of this bracket 43 is positioned opposite to the tip end of the rod of the second cylinder 42.

When the first cylinder 41 is actuated and its rod is pushed out, the light emitter unit 35 is moved to its first position (component photographing position) at which the light emitter unit 35 covers the nozzle installing portion from below. When the first cylinder 41 is actuated and its rod is pulled in, and the second cylinder is also in the state having its rod pulled in, the light emitter unit 35 is moved to the second position (optical detecting means operating position) away from the nozzle installing portion as shown in Figs.5(a) and 5(b). Further, when the first cylinder 41 is in the state having its rod pulled in and the second cylinder is in the state having its rod pushed out, the light emitter unit 35 is moved to the third position (substrate photographing position) at which the through hole 39 corresponds to the substrate photographing camera 48 as shown in Figs.6(a) and 6(b).

To detect these three positions, the head unit 5 is provided with position detecting means composed of three sensors for detecting a dog 45 provided on the light emitter unit 35 at each of the positions above.

Fig.7 shows an embodiment of the control system. In this diagram, the Y axis servomotor 9, X axis servomotor 15, Z axis servomotors 23,24 and R axis servomotors 25,26 for attracting nozzles 21,22 of the head unit 5, and position detecting means 10,16,27 through 30 provided on these servomotors are electrically connected to the axis controller (driver) 51 of the main controller 50. The laser unit 31 is electrically connected to the laser unit processor 55, which is connected to the main processor 53 through the input/output means 52 of the main controller 50. Further, position detecting means 46, light emitter unit driving means 40 and light emitter 36 for the light emitter unit 35 are connected to the input/output means 52.

The substrate recognizing camera 48 equipped on the head unit 5 and the component recognizing camera 33 installed on the base 1 of the mounting machine are connected to the image processing section 54 provided in the main controller 50. The image processing section 54 reads the image of the chip component taken by the component recognizing camera 33 and processes the image as specified to detect the center position and rotating angle, etc., of the chip component when the chip component attracted state is detected on the basis of the image taken by the component recognizing camera 33. Further, the image processing section 54 reads the image sent from the substrate recognizing camera 48 and processes the image as specified to detect the mark attached on the substrate 3 when recognizing the substrate to detect the position of the substrate 3.

The main processor 53 selects one from the laser unit 31 and the component recognizing camera 33 so as to be used for detecting the component attracted state according to the kind, etc., of the components while controlling the operations of servomotors 9,15,23 through 26 through the axis driver 51 so that attraction and mounting of components may be automatically carried out, and controls according to this selection. That is, the laser unit is selected when the component attracted state can be detected by the laser unit 31 and the component recognizing camera 33 is selected for a component the attracted state of which is difficult to be detected by the laser unit 31, for example, for chip components having many lead pins projecting therefrom, and processes for detecting the component attracted state and controls the light emitter unit driving means 40 according to such selection.

The control by the main controller 50 is described referring to Figs.4 through 6 on the basis of flow charts of Figs.8 through 10.

Fig.8 shows a routine for detecting the component attracted state by the component recognizing camera. In this routine, at the step S1, the first and second attracting nozzles are raised by the Z axis servomotors 23,24. At the step S2, it is decided whether both nozzles 21,22 were raised into the range where the light emitter unit 35 is movable without interfering with both nozzles 21,22 or not, and, when this decision is yes, the light emitter unit 35 is moved to the first position at the step S3. Then, when it is decided that the movement of the light emitter unit 35 has been completed at the step S4, the head unit 5 is moved to the component mounting position by the Y axis and X axis servomotors 9 and 15 at the step S5, and only the the first attracting nozzle 21 is lowered by the Z axis servomotor at the step S6. In this case, since the through hole 39 is at the position corresponding to the first attracting nozzle 21 when the light emitter unit 35 is at the first position, the first nozzle 21 can be lowered through the through hole 39.

After lowering above, a chip component is attracted to the first attracting nozzle 21 at the step S7. Then, while the first attracting nozzle 21 is raised until the chip component attracted to the first attracting nozzle 21 reaches a height lower than the light emitter unit 35 and appropriate for photographing at the step S8, the head unit 5 is moved to a position above the component recognizing camera 33 at the step S9.

Then, the light emitter unit 35 emits light at the step S10, and the chip component is photographed by the component recognizing camera 33 at the step S11. At the step S12, the chip component is recognized, the component attracted state is detected and the correction amount is obtained by the image processing section 54. As the process here,the image of the chip component is scanned at the image processing section 54, the center position and the rotating angle about the R axis of the chip component are obtained on the basis of this scanning, and the correction amounts in the X, Y and rotational directions are obtained from the positional deviation of the component center point relative to the component attracting point of the attracting nozzle and the rotating angle deviation.

Next, the component is mounted at the step S13, that is, when the head unit is moved to a position above the substrate 3 and the attracting nozzle 21 reaches the corrected component mounting position, the attracting nozzle is lowered and the chip component is mounted on the substrate 3.

With such a process as shown in Fig.8, the light emitter unit 35 is brought to the first position to make it possibe to recognize the component by photographing as shown also in Fig.4, only the first nozzle 21 among the attracting nozzles of the head unit 5 is used, and the chip component 20A is attracted and mounted by this attracting nozzle 21. In this case, since the through hole 39 is at the position corresponding to the first nozzle 21, the attracting nozzle 21 can be raised/lowered through this hole 39 to attract and mount a chip component. Although the chip component 20A requiring component recognition by photographing is usuaily of larger size, if the first attracting nozzle 21 is disposed near the center of the domain corresponding to the space 32 above, there is no trouble even if the attracted component is of larger size.

After the component is attracted, the attracted state of the component is detected by image processing on the basis of the image obtained by the component recognizing camera 33. In this case, since the light emitter unit 35 constitutes a background for the chip component being photographed while functioning as a lighting, a clear image can be obtained.

Fig.9 show the routine for detecting the component attracted state with the laser unit 31. In this routine, first, the first and second attracting nozzles 21,22 are raised at the step S21, and, at the step S22, it is decided whether both nozzles 21,22 were raised into the range where the light emitter unit 35 is movable without interfering with both nozzles 21,22 or not, and, when this decision is yes, the light emitter unit 35 is moved to the second position at the step S23. Then, when it is confirmed at the step S24 that the movement of the light emitter unit 35 has been completed, the component is attracted at the step S25; that is, while the head unit 5 is moved to the component attracting position, both first and second attracting nozzles 21,22 are actuated and a chip component is attracted to each of both nozzles.

Then, at the step S26, the component is recognized (component attracted state is detected) by the laser unit 31. and the correction amounts are obtained. As the process here, for example, while the chip components attracted to the attracting nozzles 21,22 are rotated in a state kept at a height position corresponding to the laser unit 31, laser beams are emitted from the laser beam generating section 31a, the projection width of the chip component is detected by the detector 31b receiving the laser beam above, and the correction amounts in the X axis, Y axis and rotational directions are obtained from the projection width, center point, rotation angle, etc., obtained at the position where the projection width becomes minimum. After this process, the components are mounted at the step S27.

With such a process as shown in Fig.9, the light emitter unit is moved to the second position where the light emitter unit does not interfere with the up/down movement of both attracting nozzles 21,22 as shown also in Fig.5, and the chip components 20B are attracted and mounted by both attracting nozzles 21,22.

After the components are attracted, the attracted states of the components are detected on the basis of the projection by the laser unit 31.

Since this process is continued also while the head unit 5 is moved from the component feeding section 4 to the position above the substrate, the overall production efficiency is elevated. The production efficiency is elevated also because both of first and second attracting nozzles 21,22 are used.

Fig. 10 shows the routine for substrate recognizing process. In this routine, first, at the step S31, the head unit 5 is moved to a position above the recognizing mark attached on the substrate. Then, the first and second attracting nozzles 21,22 are raised at the step S32, and it is decided whether both nozzles 21,22 have been raised into the range where the light emitter unit 35 can be moved without interference with both nozzles 21,22 or not at the step S33. When this decision is yes, the light emitter unit 35 is moved to the third position at the step S4. Then, when it is confirmed at the step S35 that the movement of the light emitter unit 35 has been completed, the light emitter unit emits light at the step S36, and the substrate 3 is photographed in this state by the substrate recognizing camera 48 at the step S37. Then, at the step S38, the mark attached on the substrate 3 is recognized by image processing at the image processing section 54, and its position is detected.

With such a substrate recognizing process as shown in Fig.10, the mark of the substrate 3 is investigated by the substrate recognizing camera 48 installed on the head unit 5. In this case, as shown also in Fig.6, the light emitter unit 35 is moved to the third position, and the through hole 39 is brought to the position corresponding to the substrate recognizing camera 48. In this state, the light emitter unit 35 is used as lighting for photographing the substrate 3.

The practical structure of this invention can be variously modified from the embodiment above. For example, although the embodiment above is equipped with a light emitter unit 35 having a light emitter 36 and a diffusing plate 37 on the head unit 5, another structure is possible in which the light emitter is installed on the base and a reflector plate is installed on the head unit so as to constitute a background for photographing the component.

Although the embodiment above is provided with one first attracting nozzle 21 and one second attracting nozzle 22, and only the first nozzle 21 is used when the component recognizing camera is used while both attracting nozzles 21 and 22 are used when the laser unit is used, two or more second nozzles may be used when the laser unit is used, and, in such a case, the first nozzle may be used exclusively for the case where the component recognizing camera is used. Still further, the mounting machine may be provided with a plurality of first nozzles.

Since the component attracted state detecting system for the component mounting machine according to this invention is provided, in addition to optical detecting means for detecting the component attracted state on the basis of the projection, with photographing means for detecting the component attracted state on the basis of the photograph image so that the photographing means and optical detecting means may be used selectively, and it is possible to appropriately use the photographing means and the optical detecting means for detecting the component attracted state selectively according to the kind of components.

Especially when the photographing means is used, the photographing assisting member may constitute a background for obtaining clear image while making the operation of the first nozzle possible.

On the other hand, when the optical detecting means is used, a series of operations such as attraction of chip components, detection of component attracted state, component mounting, etc., can be carried out efficiently in the state with the photographing assisting member kept away from the nozzle installing portion so that it may not interfere the operation of each attracting nozzle.

Preferably, the head unit is provided with first and second attracting nozzles and is said photographing assisting member having a portion constituting a background when photographing and a through hole bored at a specific position and photographing assisting member driving means for moving the photographing assisting member to the position for the component photographing or to the position for the optical detecting means.

Further, if the head unit is provided with substrate photographing means, the photographing assisting member is provided with a light emitter, and the photographing assisting member is so constructed that the through hole thereof can be brought also to the position for substrate photographing corresponding to the substrate photographing means in this invention, the light emitter can be used for lighting both when photographing the component and when photographing the substrate, and the substrate can be photographed with a simple structure.

## Claims

1. Method for mounting a minute component onto a substrate, said component being attracted by means of an attracting nozzle disposed on a head unit (5), wherein said component is subject to an attracted state detecting investigation performed by component attracted state detecting systems comprised of an optical detecting means on the basis of a laser unit (31) and a photographing means on the basis of a component recognising camera (33), **characterised in that** a main processor (53) of a main controller (50) selects one of said component recognising camera (33) in response to components (20A,20B) having many lead pins and said laser unit (31) in response to other types of components (20A,20B) to be mounted.

2. Method for mounting a component as claimed in claim 1 **characterised in that** said main processor (53) of said main controller (50) controls the operations of several motors (9,15,23 to 26) through an axis driver unit (51) to automatically attract and mount said components according to the selection of the means for investigating the attracted state of the component (20A,20B).

3. Method for mounting a component as claimed in claims 1 or 2, **characterised in that,** the detection of the component attracting state by the component recognising camera (33) comprises raising of a first and second attracting nozzle (21,22) by respective vertical Z-axis servo motors (23,24), moving a light beam emitting unit (35) as photographing assisting means in a first photographing assisting position, moving the head unit (5) by operating Y-axis and X-axis servo motors (9,15) to the component mounting position and lowering the first attracting nozzle (21) only through the associated Z-axis servo motor (23) to insert the first attracting nozzle (21) into a through hole (39) of the light beam emitting unit (35) to attract a chip component (20A), then raising the first nozzle (21) until the chip component (20A) attracted to the first attracted nozzle (21) reaches a height lower than that of said light beam emitting unit (35) and appropriate for photographing while the head unit (5) is moved then to a position above the component recognising camera (33) and, on the light emission through the light beam emitting unit (35), the component (20A) is photographed by the component recognising camera (33).

4. Method for mounting a component as claimed in claim 3, **characterised in that,** the component (20A) is recognised, the component attracted state is detected and a correction amount for positioning the component (20A) on the substrate is obtained by an image processing section (54) of the main controller (50).

5. Method for mounting a component as claimed in claim 4, **characterised in that** the photograph image of the component (20A) is scanned at the image processing section (54), a centre position and a rotating angle about the R-axis of the component (20A) are obtained on the basis of said scanning and correction amounts of the X-,Y- and rotational directions are obtained from the positional deviation of a component centre point relative to a component attracting point of the attracting nozzle (21) and a deviation of the rotating angle.

6. Method for mounting a component as claimed in claim 3 or 4, **characterised in that** a detection of the component attracting state by the optical detecting means comprises raising of the first and second attracting nozzles (21,22), moving the light beam emitting unit (35) to a second operating position of the optical detecting means (31), moving the head unit (5) to the component attracting position actuating both first and second attracting nozzles (21,22) and attracting components (20A,20B) to each of said attracting nozzles (21,22), recognising the components (21,22) by the optical detecting means (31) and obtaining correction amounts, preferably while the components (20A,20B) attracted to the attracting nozzles (21,22) are rotated in a state kept at a height position correspond to the height of the emitting laser beam from the laser beam generating section (31a) of the optical detecting means (31) detecting the projection width of the chip components (20A,20B) by the light beam receiving section (31b) of the optical detecting means (31) and obtaining correction amounts in the X-axis, Y-axis and rotational directions at the position where the projection width becomes minimal.

7. Method for mounting a component as claimed in at least one of the preceding claims 1 to 6, **characterised in that,** a substrate recognising process is carried out moving the head unit (5) to a position above a recognising mark attached onto the substrate, raising the first and second attracting nozzles (21,22) moving the photographing assisting means comprising the light beam emitting unit (35) to a third position to emit light onto the substrate (3), photographing the lightened substrate (3) by a substrate recognising camera (48) and recognising by image processing at the image processing section (54) of the main controller (50) the position of the mark attached on the substrate (3).

8. Component mounting machine comprising a moveable head unit (5) supporting a plurality of attracting nozzles (21,22) for attracting by vacuum at least one component (20A,20B) to be mounted, for mounting said component (20A,20B) at a predetermined position onto a substrate, specifically onto a printed circuit board, said head unit (5) comprising a detecting system (31) for detecting the attracted state of the electrical or electronic components (20A,20B) to said attracting nozzles (21,22) for performing the method as claimed in claim 1, **characterised in that** at least one photographing means (33) is provided for detecting the attracted state of a component having many lead pins on the basis of a photograph.

9. Component mounting machine as claimed in claim 8, **characterised in that,** said photographing means is a component recognising camera (33) disposed on a base (1) of the machine.

10. Component mounting machine as claimed in claims 8 and 9, **characterised in that,** the detecting system comprising an optical detecting means (31) and that said optical detecting means (31) and said photographing means (33) being alternatively used in response to the type of component to be mounted to detect the attracted state of the component (20A,20B) at a selected attracting nozzle (21,22).

11. Component mounting machine as claimed in at least one of the preceding claims 8 to 10, **characterised in that,** said head unit (5) comprises at least one first attracting nozzle (21) and at least one second attracting nozzle (22), said second attracting nozzle (22) being exclusively used when said optical detecting means (31) is used to detect the attracted state of the component (20A,20B).

12. Component mounting machine as claimed in claim 11 **characterised in that** said attracting nozzles (21,22) being moveable together with the head unit (5) in the directions of a X- or Y-axis defining a horizontal plane and being independently moveable in a vertical Z-axis direction while each of said attracting nozzles (21,22) being independently rotatable about its vertical axis (R).

13. Component mounting machine as claimed in at least one of the preceding claims 8 to 12, **characterised in that,** said photographing means (33) comprising a photographing assisting member (35,36,37,38) which at least partially constitutes a background for photographing, said photographing assisting member (35,36,37,38) having a through hole (39) for accommodating therethrough an attracting nozzle (21) when photographing same.

14. Component mounting machine as claimed in claim 13, **characterised in that** a driving means (40,41,42) for driving the photographing assisting member (35,36,37,38) is provided for moving the photographing assisting member (35,36,37,38) from a component photographing position covering a nozzle installation portion of the head unit (5) from below to an operating position of the optical detecting means (31) in which the photographing assisting member (35,36,37,38) is kept away from said nozzle installation portion of the head unit (5), or vice versa.

15. Component mounting machine as claimed in at least one of the preceding claims 10 to 14, **characterised in that,** said optical detecting means (31) being provided at the head unit (5) and comprises a parallel light beam emitting section (31a) and a light beam receiving section (31b) for detecting the attracted state of the component (20A,20B) on the basis of the detection of a projection of said component (20A,20B), specifically chip component, attracted to one of the attracting nozzles (21,22), respectively.

16. Component mounting machine as claimed in claim 15, **characterised in that,** said optical detecting means comprises a laser unit (31).

17. Component mounting machine as claimed in claim 13, **characterised in that,** said photographing assisting member comprises a moveable light beam emitting unit (35) having a plate-like light emitter (36) composed of a plurality of LED's, a diffusing plate (37) positioned on the light emitter (36) and a mounting member (38) for combining the light emitter (36) and the diffusing plate (37).

18. Component mounting machine as claimed in at least one of the preceding claims 8 to 17, **characterised in that,** another photographing means (48) for photographing the substrate is provided.

19. Component mounting machine as claimed in claim 18, **characterised in that,** said substrate photographing means (48) is supported through the head unit (5).

20. Component mounting machine as claimed in at least one of the preceding claims 13 to 19, **characterised in that,** said photographing assisting member (35,36,37,38) is adapted to be moved towards a substrate photographing position through its driving means (40,41,42), said substrate photographing position corresponds to a position of the substrate photographing means (48).

21. Component mounting machines as claimed in at least one of the preceding claims 8 to 20, **characterised in that,** the head unit (5) slideably and rotatably supports one first attracting nozzle (21) and one second attracting nozzle (22) disposed substantially parallel to each other supports the laser unit (31) as optical detecting means for detecting the attracted state of the chip components (20A,20B) on the basis of their projection, the photographing assisting member (35,36,37,38) including the light beam emitting unit (35) and the substrate recognising camera (48) as substrate photographing means.

22. Component mounting machine as claimed in at least one of the preceding claims 8 to 21, **characterised in that,** a control system is provided comprising a main controller (50) which comprises an axis controller driver circuit (51), input/output means (52), a main processor (53) and an image processing section (54).

23. Component mounting machine as claimed in claim 22, **characterised in that,** the substrate recognising camera (48) equipped on the head unit (5) and the component recognising camera (33) installed on the base (1) of the mounting machine are connected to the image processing section (54) of the main controller (50).

## Patentansprüche

1. Verfahren zum Montieren eines kleinen Bauteiles auf einem Substrat, wobei das Bauteil durch eine Ansaugdüse, angeordnet an einer Kopfeinheit (5), angezogen wird, wobei das Bauteil einer Erfassungsuntersuchung im angezogenen Zustand, ausgeführt durch Erfassungssysteme für das Bauteil im angezogenen Zustand, die eine optische Erfassungseinrichtung auf der Grundlage einer Lasereinheit (31) und eine fotografische Einrichtung auf der Basis einer Bauteil-Erfassungskamera (33) enthält, **dadurch gekennzeichnet,** daß ein Hauptprozessor (53) einer Hauptsteuerung (50) die Bauteil-Erfassungskamera (33) für den Fall, daß die Bauteile (20A, 20B) viele Leitungsstifte aufweisen und die Lasereinheit (31) für den Fall, daß andere Arten von Bauteilen (20A, 20B) montiert werden sollen, auswählt.

2. Verfahren zur Montage eines Bauteiles nach Anspruch 1, **dadurch gekennzeichnet,** daß der Hauptprozessor (53) der Hauptsteuerung (50) die Betätigungen von verschiedenen Motoren (9, 15, 23 bis 26) durch eine Achsen-Treibereinheit (51), um die Bauteile automatisch anzuziehen und zu montieren, entsprechend der Auswahl der Einrichtung zur Untersuchung des angezogenen Zustandes des Bauteils (20A, 20B).

3. Verfahren zur Montage eines Bauteiles nach Anspruch 1 oder 2, **dadurch gekennzeichnet,** daß die Erfassung des Bauteil-Anzugszustandes durch die Bauteil-Erfassungskamera (33) umfaßt das Anheben einer ersten und zweiten Ansaugdüse (21, 22) durch jeweilige Vertikal-Z-Achsen-Servomotoren (23, 24), Bewegen einer Lichtstrahl-Emittiereinheit (35) als fotografische Unterstützungseinrichtung in eine erste fotografische Unterstützungsposition, Bewegen der Kopfeinheit (5) durch Betätigen von Y-Achsen- und X-Achsen-Servomotoren (9, 15) zu der Bauteil-Montageposition und Absenken der ersten Ansaugdüse (21) nur durch den zugehörigen Z-Achsen-Servomotor (23), um die erste Ansaugdüse (21) in eine Durchgangsöffnung (39) der Lichtstrahl-Emittiereinheit (35) einzusetzen, um ein Chip-Bauteil (20A) anzuziehen, anschließendes Anheben der ersten Düse (21), bis das Chip-Bauteil (20A), angezogen an der ersten Ansaugdüse (21) eine Höhe erreicht, die niedriger ist als diejenige der Lichtstrahl-Emittiereinheit (35) und die zum Fotografieren geeignet ist, während die Kopfeinheit (5) anschließend in eine Position oberhalb der Bauteil-Erkennungskamera (33) bewegt wird, und unter Lichtemission durch die Lichtstrahl-Emittiereinheit (35) das Bauteil (20A) durch die Bauteil-Erkennungskamera (33) fotografiert wird.

4. Verfahren zur Montage eines Bauteiles nach Anspruch 3, **dadurch gekennzeichnet,** daß das Bauteil (20A) erkannt wird, der Bauteil-Anzugszustand erfaßt wird und ein Korrekturbetrag für die Positionierung des Bauteiles (20A) auf dem Substrat durch einen Bildverarbeitungsabschnitt (54) der Hauptsteuerung (50) erhalten wird.

5. Verfahren zur Montage eines Bauteiles nach Anspruch 4, **dadurch gekennzeichnet,** daß das Fotografierbild des Bauteiles (20A) in dem Bildverarbeitungsabschnitt (54) eingelesen wird, eine Mittelposition und ein Drehwinkel um die R-Achse des Bauteiles (20A) auf der Basis der eingelesenen und Korrektur-Beträge der X-, Y- und Drehrichtungen aus der Positions-Ableitung eines Bauteil-Mittelpunktes relativ zu einem Bauteil-Anzugspunkt der Ansaugdüse (21) und einer Abweichung des Drehwinkels erhalten werden.

6. Verfahren zur Montage eines Bauteiles nach Anspruch 3 oder 4, **dadurch gekennzeichnet,** daß eine Erfassung des Bauteil-Anzugszustandes durch die optische Erfassungseinrichtung enthält das Anheben der ersten und zweiten Ansaugdüse (21, 22), Bewegen der Lichtstrahl-Emittiereinheit (35) in eine zweite Arbeitsposition der optischen Erfassungseinrichtung (31), Bewegen der Kopfeinheit (5) zu der Bauteil-Ansaugposition, unter Betätigen sowohl der ersten als auch der zweiten Ansaugdüse (21, 22) und Anziehen der Bauteile (20A, 20B) an jede der Ansaugdüsen (21, 22), Erkennen der Bauteile (21, 22) durch die optische Erfassungseinrichtung (31) und Erhalten von Korrekturbeträgen, vorzugsweise während die Bauteile (20A, 20B), die an den Ansaugdüsen (21, 22) angezogen sind, in einem Zustand gedreht werden, bei dem ihre Höhenposition beibehalten wird, die der Höhe der Aussendung eines Laserstrahles von dem Laserstrahl-Erzeugungsabschnitt (31A) der optischen Erfassungseinrichtung (31) entspricht, Erfassen der Projektionsbreite der Chip-Bauteile (20A, 208) durch den Lichtstrahl-Aufnahmeabschnitt (31B) der optischen Erfassungseinrichtung (31) und Erhalten der Korrekturbeträge in X-Achsen-, Y-Achsen und Drehrichtungen in der Stellung, in der die Projektionsbreite minimal wird.

7. Verfahren zur Montage eines Bauteiles nach zumindest einem der vorhergehenden Ansprüche 1 bis 6, **dadurch gekennzeichnet,** daß ein Substrat-Erkennungsprozeß ausgeführt wird, in dem die Kopfeinheit (5) in eine Position oberhalb einer Erkennungsmarke, die auf dem Substrat aufgebracht ist, bewegt wird, Anheben der ersten und zweiten Ansaugdüse (21, 22), bewegen, der Fotografier-Unterstützungseinrichtung, die die Lichtstrahl-Emittiereinheit (35) aufweist, in eine dritte Position, um Licht auf das Substrat (3) zu emittieren, Fotografieren des beleuchteten Substrates (3) durch eine Substrat-Erkennungskamera (48) und Erkennen der Position der Markierung, die sich auf dem Substrat (3) befindet durch Bildverarbeitung in dem Bildverarbeitungsabschnitt (54) der Hauptsteuerung (50).

8. Bauteil-Montagemaschine mit einer beweglichen Kopfeinheit (5), die eine Mehrzahl von Ansaugdüsen (21, 22) lagert, um durch Vakuum zumindest ein Bauteil (20A, 20B), das montiert werden soll, anzuziehen, zur Montage dieses Bauteils (20A, 20B) in einer vorgegebenen Position auf einem Substrat, insbesondere auf einer Leiterplatte, wobei die Kopfeinheit (5) ein Erfassungssystem (31) zur Erfassung des Anzugszustandes der elektrischen oder elektronischen Bauteile (20A, 208) an den Ansaugdüsen (21, 22) aufweist, zur Durchführung des Verfahrens nach Anspruch 1, **dadurch gekennzeichnet,** daß zumindest eine fotografische Einrichtung (33) zur Erfassung des angezogenen Zustandes eines Bauteiles, das viele Leitungsstifte besitzt, auf der Basis einer Fotografie vorgesehen ist.

9. Bauteil-Montagemaschine nach Anspruch 8, **dadurch gekennzeichnet,** daß die fotografische Einrichtung eine Bauteil-Erkennungskamera (33) ist, die an einer Basis (1) der Maschine angeordnet ist.

10. Bauteil-Montagemaschine nach Anspruch 8 oder 9, **dadurch gekennzeichnet,** daß das Erfassungssystem aufweist eine optische Erfassungseinrichtung (31), und daß die optische Erfassungseinrichtung (31) und die fotografische Einrichtung (33) alternativ in Abhängigkeit von der Art des Bauteiles, das montiert werden soll, verwendet werden, um den angezogenen Zustand des Bauteiles (20A, 20B) an einer ausgewählten Ansaugdüse (21, 22) zu erfassen.

11. Bauteil-Montagemaschine nach zumindest einem der vorhergehenden Ansprüche 8 bis 10, **dadurch gekennzeichnet,** daß die Kopfeinheit (5) zumindest eine erste Ansaugdüse (21) und zumindest eine zweite Ansaugdüse (22) aufweist, wobei die zweite Ansaugdüse (22) ausschließlich dann verwendet wird, wenn die optische Erfassungseinrichtung (31) verwendet wird, um den angezogenen Zustand des Bauteiles (20A, 20B) zu erfassen.

12. Bauteil-Montagemaschine nach Anspruch 11, **dadurch gekennzeichnet,** daß die Ansaugdüsen (21, 22) gemeinsam mit der Kopfeinheit (5) in Richtungen der X- oder Y-Achse, die eine Horizontalebene festlegen, bewegbar sind und unabhängig voneinander in einer vertikalen Z-Achsenrichtung bewegbar sind, während jede der Ansaugdüsen (21, 22) unabhängig um ihre Vertikalachse (R) drehbar ist.

13. Bauteil-Montagemaschine nach zumindest einem der vorhergehenden Ansprüche 8 bis 12, **dadurch gekennzeichnet,** daß die fotografische Einrichtung (33) aufweist ein Fotografier-Unterstützungsteil (35, 36, 37, 38), welches zumindest teilweise einen Hintergrund für das Fotografieren bildet, wobei das Fotografier-Unterstützungsteil (35, 36, 37,38) eine Durchgangsöffnung (39) aufweist, um durch diese hindurch eine Ansaugdüse (21) aufzunehmen, wenn diese fotografiert wird.

14. Bauteil-Montagemaschine nach Anspruch 13, **dadurch gekennzeichnet,** daß eine Antriebseinrichtung (40, 41, 42) zum Antreiben des Fotografier-Unterstützungsteiles (35, 36, 37, 38) vorgesehen ist, um das Fotografier-Unterstützungsteil (35, 36, 37, 38) aus einer Bauteil-Fotografierposition, in der ein Düsen-lnstallationsabschnitt der Kopfeinheit (5) von unten abgedeckt ist, in eine Arbeitsposition der optischen Erfassungseinrichtung (31), in der das Fotografier-Unterstützungsteil (35, 36, 37, 38) von dem Düsen-lnstallationsabschnitt der Kopfeinheit (5) entfernt gehalten ist, oder umgekehrt.

15. Bauteil-Montagemaschine nach zumindest einem der vorhergehenden Ansprüche 10 bis 14, **dadurch gekennzeichnet,** daß die optische Erfassungseinrichtung (31) an der Kopfeinheit (5) vorgesehen ist und einen parallele Lichtstrahlen emittierenden Abschnitt (31a) und einen Lichtstrahl-Aufnahmeabschnitt (31b) zur Erfassung des Anzugszustandes des Bauteiles (20A, 20B) auf der Basis der Erfassung einer Projektion dieses Bauteiles (20A, 20B), insbesondere eines Chip-Bauteiles, jeweils angezogen an eine der Ansaugdüsen (21, 22) aufweist.

16. Bauteil-Montagemaschine nach Anspruch 15, **dadurch gekennzeichnet,** daß die optische Erfassungseinrichtung eine Lasereinheit (31) aufweist.

17. Bauteil-Montagemaschine nach Anspruch 13, **dadurch gekennzeichnet,** daß das Fotografier-Unterstützungsteil eine bewegliche Lichtstrahl-Emittiereinheit (35), die einen plattenförmigen Lichtemitter (36), bestehend aus einer Mehrzahl von LED's, eine Diffusionsplatte (37), angeordnet auf dem Licht-Emitter (36) und ein Montageteil (38) zur Kombination des Licht-Emitters (36) und der Diffusionsplatte (37) aufweist.

18. Bauteil-Montagemaschine nach zumindest einem der vorhergehenden Ansprüche 8 bis 17, **dadurch gekennzeichnet,** daß eine weitere Fotografiereinrichtung (48) zum Fotografieren des Substrates vorgesehen ist.

19. Bauteil-Montagemaschine nach Anspruch 18, **dadurch gekennzeichnet,** daß die Substrat-Fotografiereinnchtung (48) durch die Kopfeinheit (5) gelagert ist.

20. Bauteil-Montagemaschine nach zumindest einem der vorhergehenden Ansprüche 13 bis 19, **dadurch gekennzeichnet,** daß das Fotografier-Unterstützungsteil (35, 36, 37, 38) vorgesehen ist, in Richtung auf eine Substrat-Fotografierposition durch seine Antriebseinrichtung (40, 41, 42) bewegt zu werden, wobei die Substrat-Fotografierposition einer Position der Substrat-Fotografiereinrichtung (48) entspricht.

21. Bauteil-Montagemaschine nach zumindest einem der vorhergehenden Ansprüche 8 bis 20, **dadurch gekennzeichnet,** daß die Kopfeinheit (5) gleitbar und drehbar eine erste Ansaugdüse (21) und eine zweite Ansaugdüse (22) lagert, die im wesentlichen parallel zueinander angeordnet sind, die Lasereinheit (31) als optische Erfassungseinrichtung zur Erfassung des angezogenen Zustandes der Chip-Bauteile (20A, 20B) auf der Basis ihrer Projektion lagert, sowie das Fotografier-Unterstützungsteil (35, 36, 37, 38) einschließlich der Lichtstrahl-Emittiereinheit (35) und die Substrat-Erkennungskamera (48) als Substrat-Fotografiereinnchtung lagert.

22. Bauteil-Montagemaschine nach zumindest einem der vorhergehenden Ansprüche 8 bis 21, **dadurch gekennzeichnet,** daß ein Steuersystem vorgesehen ist, enthaltend eine Haupt-Steuerung (50), die eine Achsensteuerungs-Treiberschaltung (51), Eingabe-/Ausgabe-Mittel (52), einen Hauptprozessor (53) und einen Bildverarbeitungsabschnitt (54).

23. Bauteil-Montagemaschine nach Anspruch 22, **dadurch gekennzeichnet,** daß die Substrat-Erkennungskamera (48), angeordnet an der Kopfeinheit (5), und die Bauteil-Erkennungskamera (33), angeordnet an der Basis (1) der Montagemaschine, mit dem Bildverarbeitungsabschnitt (54) der Hauptsteuerung (50) verbunden sind.

## Revendications

1. Procédé de montage d'un minuscule composant sur un substrat, ledit composant étant attiré par l'intermédiaire d'une buse d'attraction disposée sur une unité de tête (5), dans lequel ledit composant est soumis à un examen de détection d'état attiré, effectué par des systèmes de détection d'état attiré de composant constitués de moyens de détection optique fonctionnant sur la base d'une unité laser (31) et de moyens de photographie fonctionnant sur la base d'un appareil photographique de reconnaissance de composant (33), caractérisé en ce qu'un processeur principal (53) d'une commande principale (50) sélectionne l'un parmi ledit appareil photographique de reconnaissance de composant (33), en réponse à des composants (20A, 20B) ayant plusieurs broches de plomb, et ladite unité laser (31), en réponse aux autres types de composant (20A, 20B) à monter.

2. Procédé de montage d'un composant selon la revendication 1, caractérisé en ce que ledit processeur principal (53) de ladite commande principale (50) commande les fonctionnements de plusieurs moteurs (9, 15, 23 à 26) par l'intermédiaire d'une unité d'entraînement d'axes (51) pour attirer automatiquement et monter lesdits composants conformément à la sélection des moyens d'examen de l'état attiré du composant (20A, 20B).

3. Procédé de montage d'un composant selon la revendication 1 ou 2, caractérisé en ce que la détection de l'état d'attraction du composant par l'appareil photographique de reconnaissance de composant (33) comporte les étapes consistant à soulever une première et une seconde buse d'attraction (21, 22) par des servomoteurs respectifs (23, 24) à axe Z vertical, déplacer une unité d'émission de faisceau lumineux (35) en tant que moyens d'aide à la photographie vers une première position d'aide à la photographie, déplacer l'unité de tête (5) en actionnant des servomoteurs à axe Y et à axe X (9, 15) vers la position de montage de composant et diminuer la première buse d'attraction (21) uniquement par l'intermédiaire du servomoteur à axe Z associé (23) pour insérer la première buse d'attraction (21) dans un trou traversant (39) de l'unité d'émission de faisceau lumineux (35) pour attirer un composant de puce (20A), à soulever ensuite la première buse (21) jusqu'à ce que le composant de puce (20A) attiré vers la première buse d'attraction (21) atteigne une hauteur inférieure à celle de ladite unité d'émission de faisceau lumineux (35) et appropriée pour la photographie, alors que l'unité de tête (5) est ensuite déplacée jusqu'à une position située au-dessus de l'appareil photographique de reconnaissance de composant (33) et, lors de l'émission de lumière à travers l'unité d'émission de faisceau lumineux (35), le composant (20A) est photographié par l'appareil photographique de reconnaissance de composant (33).

4. Procédé de montage d'un composant selon la revendication 3, caractérisé en ce que le composant (20A) est reconnu, l'état attiré du composant est détecté et une valeur de correction pour positionner le composant (20A) sur le substrat est obtenue par une partie de traitement d'image (54) de la commande principale (50).

5. Procédé de montage d'un composant selon la revendication 4, caractérisé en ce que l'image de photographie du composant (20A) est balayée au niveau de la partie de traitement d'image (54), une position centrale et un angle de rotation autour de l'axe R du composant (20A) sont obtenus sur la base dudit balayage, et des valeurs de correction des directions X, Y et de la direction de rotation sont obtenues à partir de la déviation de position d'un point central du composant par rapport à un point d'attraction de composant de la buse d'attraction (21) et d'une déviation de l'angle de rotation.

6. Procédé de montage d'un composant selon la revendication 3 ou 4, caractérisé en ce qu'une détection de l'état d'attraction du composant par les moyens de détection optique comporte les étapes consistant à soulever les première et seconde buses d'attraction (21, 22), déplacer l'unité d'émission de faisceau lumineux (35) vers une deuxième position de fonctionnement des moyens de détection optique (31), déplacer l'unité de tête (5) vers la position d'attraction de composant, actionner à la fois la première et la seconde buse d'attraction (21, 22) et attirer des composants (20A, 20B) vers chacune desdites buses d'attraction (21, 22), faire reconnaître les composants (20A, 20B) par les moyens de détection optique (31) et obtenir des valeurs de correction, de préférence pendant que les composants (20A, 20B) attirés vers les buses d'attraction (21, 22) sont mis en rotation dans un état maintenu à une position de hauteur qui correspond à la hauteur du faisceau laser émis par la partie de production de faisceau laser (31a) des moyens de détection optique (31), détecter la largeur de projection des composants de puce (20A, 20B) par la partie de réception de faisceau laser (31b) des moyens de détection optique (31) et obtenir les valeurs de correction dans les directions de l'axe X, de l'axe Y et dans la direction de rotation à la position où la largeur de projection devient minimale.

7. Procédé de montage d'un composant selon l'une quelconque des revendications 1 à 6, caractérisé en ce qu'un processus de reconnaissance de substrat est effectué en déplaçant l'unité de tête (5) jusqu'à une position située au-dessus d'une marque de reconnaissance fixée au substrat, en élevant les première et seconde buses d'attraction (21, 22) en déplaçant les moyens d'aide à la photographie comportant l'unité d'émission de faisceau lumineux (35) jusqu'à une troisième position pour émettre une lumière sur le substrat (3), en photographiant le substrat éclairé (3) par un appareil photographique de reconnaissance de substrat (48) et en reconnaissant par un traitement d'image situé au niveau de la partie de traitement d'image (54) de la commande principale (50) la position de la marque fixée au substrat (3).

8. Machine de montage de composant comportant une unité de tête mobile (5) supportant plusieurs buses d'attraction (21, 22) pour attirer par le vide au moins un composant (20A, 20B) à monter, pour monter ledit composant (20A, 20B) à une position prédéterminée sur un substrat, en particulier sur une carte de circuit imprimé, ladite unité de tête (5) comportant un système de détection (31) pour détecter l'état attiré des composants électriques ou électroniques (20A, 20B) vers lesdites buses d'attraction (21, 22), pour mettre en oeuvre le procédé selon la revendication 1, caractérisée en ce qu'au moins des moyens de photographie (33) sont agencés pour détecter l'état attiré d'un composant ayant plusieurs broches de plomb sur la base d'une photographie.

9. Machine de montage de composant selon la revendication 8, caractérisée en ce que lesdits moyens de photographie sont un appareil photographique de reconnaissance de composant (33) disposé sur une base (1) de la machine.

10. Machine de montage de composant selon la revendication 8 et 9, caractérisée en ce que le système de détection comporte des moyens de détection optique (31) et en ce que lesdits moyens de détection optique (31) et lesdits moyens de photographie (33) sont utilisés de manière alternée en réponse au type de composant à monter pour détecter l'état attiré du composant (20A, 20B) au niveau d'une buse d'attraction sélectionnée (21, 22).

11. Machine de montage de composant selon l'une quelconque des revendications 8 à 10, caractérisée en ce que ladite unité de tête (5) comporte au moins une première buse d'attraction (21) et au moins une seconde buse d'attraction (22), ladite seconde buse d'attraction (22) étant exclusivement utilisée lorsque lesdits moyens de détection optique (31) sont utilisés pour détecter l'état attiré du composant (20A, 20B).

12. Machine de montage de composant selon la revendication 11, caractérisée en ce que lesdites buses d'attraction (21, 22) peuvent se déplacer ensemble avec l'unité de tête (5) dans les directions d'un axe X ou d'un axe Y définissant un plan horizontal et peuvent se déplacer indépendamment dans une direction d'axe Z vertical alors que chacune desdites buses d'attraction (21, 22) peut tourner indépendamment autour de son axe vertical (R).

13. Machine de montage de composant selon l'une quelconque des revendications 8 à 12, caractérisée en ce que lesdits moyens de photographie (33) comportent un élément d'aide à la photographie (35, 36, 37, 38) qui constitue au moins partiellement un arrière-plan de photographie, ledit élément d'aide à la photographie (35, 36, 37, 38) ayant un trou traversant (39) pour recevoir à travers celui-ci une buse d'attraction (21) lorsqu'elle est photographiée.

14. Machine de montage de composant selon la revendication 13, caractérisée en ce que des moyens d'entraînement (40, 41, 42) destinés à entraîner l'élément d'aide à la photographie (35, 36, 37, 38) sont agencés pour déplacer vers le haut l'élément d'aide à la photographie (35, 36, 37, 38) depuis une position de photographie de composant, recouvrant une partie d'installation de buse de l'unité de tête (5), jusqu'à une position de fonctionnement des moyens de détection optique (31) dans laquelle l'élément d'aide à la photographie (35, 36, 37, 38) est maintenu éloigné de ladite partie d'installation de buse de l'unité de tête (5), ou vice versa.

15. Machine de montage de composant selon l'une quelconque des revendications 10 à 14, caractérisée en ce que lesdits moyens de détection optique (31) sont agencés au niveau de l'unité de tête (5) et comportent une partie d'émission de faisceau lumineux de rayons parallèles (31a) et une partie de réception de faisceau lumineux (31b) pour détecter l'état attiré du composant (20A, 20B) sur la base de la détection d'une projection dudit composant (20A, 20B), en particulier un composant de puce, attiré vers une des buses d'attraction (21, 22), respectivement.

16. Machine de montage de composant selon la revendication 15, caractérisée en ce que lesdits moyens de détection optique comportent une unité laser (31).

17. Machine de montage de composant selon la revendication 13, caractérisée en ce que ledit élément d'aide à la photographie comporte une unité mobile d'émission de faisceau lumineux (35) ayant un émetteur de lumière du type plaque (36) constitué d'une pluralité de diodes électroluminescentes (LED), d'une plaque de diffusion (37) positionnée sur l'émetteur de lumière (36) et d'un élément de montage (38) pour combiner l'émetteur de lumière (36) et la plaque de diffusion (37).

18. Machine de montage de composant selon l'une quelconque des revendications 8 à 17, caractérisée en ce que d'autres moyens de photographie (48) sont agencés pour photographier le substrat.

19. Machine de montage de composant selon la revendication 18, caractérisée en ce que lesdits moyens de photographie de substrat (48) sont supportés par l'intermédiaire de l'unité de tête (5).

20. Machine de montage de composant selon l'une quelconque des revendications 13 à 19, caractérisée en ce que ledit élément d'aide à la photographie (35, 36, 37, 38) est adapté pour être déplacé en direction d'une position de photographie de substrat par l'intermédiaire de ses moyens d'entraînement (40, 41, 42), ladite position de photographie de substrat correspondant à une position des moyens de photographie de substrat (48).

21. Machine de montage de composant selon l'une quelconque des revendications 8 à 20, caractérisée en ce que l'unité de tête (5) supporte de manière coulissante et rotative une première buse d'attraction (21) et une seconde buse d'attraction (22) disposées pratiquement parallèles l'une à l'autre, et supporte l'unité laser (31) en tant que moyens de détection optique pour détecter l'état attiré des composants de puce (20A, 20B) sur la base de leurs projections, l'élément d'aide à la photographie (35, 36, 37, 38) comportant l'unité d'émission de faisceau lumineux (35) et l'appareil photographique de reconnaissance de substrat (48) en tant que moyens de photographie de substrat.

22. Machine de montage de composant selon l'une quelconque des revendications 8 à 21, caractérisée en ce qu'un système de commande est agencé comportant une commande principale (50) qui comporte un circuit d'entraînement de commande d'axes (51), des moyens d'entrée/sortie (52), un processeur principal (53) et une partie de traitement d'image (54).

23. Machine de montage de composant selon la revendication 22, caractérisée en ce que l'appareil photographique de reconnaissance de substrat (48) agencé sur l'unité de tête (5) et l'appareil photographique de reconnaissance de composant (33) installé sur la base (1) de la machine de montage sont connectés à la partie de traitement d'image (54) de la commande principale (50).
